Europäisches Patentamt

(19) European Patent Office

Office européen des brevets

(11) Publication number: **0 203 680**
**A2**

(12) # EUROPEAN PATENT APPLICATION

(21) Application number: **86301849.5**

(22) Date of filing: **14.03.86**

(51) Int. Cl.⁴: **H 05 K 1/00,** H 05 K 5/00, H 04 M 1/02

(30) Priority: **16.03.85 GB 8506896**

(43) Date of publication of application: **03.12.86**
**Bulletin 86/49**

(84) Designated Contracting States: **AT BE CH DE FR IT LI LU NL SE**

(71) Applicant: **MARCONI ELECTRONIC DEVICES LIMITED, The Grove Warren Lane, Stanmore Middlesex HA7 4LY (GB)**

(72) Inventor: **Mundy, Richard Joseph, 12, Cantors Way Minety, Malmesbury Wiltshire (GB)**
Inventor: **Pilcher, Heather, Shumack Hankerton Road, Upper Minety Nr. Swindon Wiltshire (GB)**

(74) Representative: **Hoste, Colin Francis, The General Electric Company p.l.c. Central Patent Department (Chelmsford Office) Marconi Research Centre West Hanningfield Road, Great Baddow Chelmsford CM2 8HN, Essex (GB)**

(54) **Electrical device including a printed circuit.**

(57) An electrical arrangement includes a structural member consisting of a moulded low-temperature thermosetting plastics material. The member acts as a substrate for an electrical circuit formed as a pattern of cured electrical polymer inks. This avoids the need in many instances for conventional flat printed circuit boards.

I/7032/MEDL

ELECTRICAL ARRANGEMENT

This invention relates to an electrical arrangement which includes as an integral part of it, an electrical circuit which is formed from what are generally termed electrical inks.

Electrical circuits are commonly formed on thin rigid insulating substrates such as alumina by the screenprinting of conductive tracks and resistors upon that surface using inks which cure at very high temperatures. Using this technique, complex electrical circuits can be fabricated in a very compact fashion, although the process can be relatively expensive. Alumina substrates are relatively fragile and expensive, and special regard must be had to the way in which they are mounted. For these reasons the adoption of this kind of circuit, which is sometimes termed a hybrid circuit, has not been as extensive as it might have been. The present invention seeks to provide an improved electrical arrangement.

According to a first aspect of this invention an electrical circuit includes a shaped non-flat electrically insulating moulded plastics substrate, a surface region of which carries circuit elements formed of a low temperature cured electrical ink of the kind which cures at a temperature of less than $200^{\circ}C$.

According to a second aspect of this invention an electrical arrangement includes a structural non-flat member formed of a moulded plastics material, a portion of the structural member also serving as a substrate for an electrical circuit which is formed at least partly of a low-temperature cured electrical ink, which is cured in contact with the plastics material.

The invention therefore resides in the use of a low-temperature plastics material which is moulded into a relatively complex shape which is dictated not primarily by the electrical function of the circuit which it carries, but by the structural function which it has to perform. Typically, the structural member will constitute the case or lid of an electrical package, or it may constitute an internal support whose presence is required for reasons other than that of carrying an electrical hybrid circuit. In certain cases, the function and shape of the member may be of a primarily decorative nature. By adopting a structural member which is inherently present in a package or housing, the overall construction is very much simplified and rendered very economical indeed. In a preferred example, a telephone hand-set (one-piece telephone) is formed out of two portions of moulded thermo-setting plastics material. These plastics members serve the functions of supporting and enclosing the parts of the telephone; microphone, earphone and a push-button dial set and the like. In addition, the inner surfaces of the moulded plastics members serve as a substrate which carry a pattern of tracks composed of low-temperature electrical inks which are cured in situ. In this way, it may not be necessary to provide the equivalent of the conventional circuit board, which is generally flat and rigid - flexible circuit boards are available but can be difficult to mount and support. The use of the invention removes a very major design constraint which is present, particularly in small and complex electrical products.

This technique makes use of the low-temperature polymer inks which are available to be screen-printed upon a substrate. The substrate in this instance takes the form of a low-temperature thermo-setting plastics material, which will invariably be moulded into the required three dimensional shape. Although the plastics material may be left with a smooth or shiny surface in those regions where the electrical circuit is to be formed, it is instead, much preferred to provide a roughened surface in the manner of our co-pending patent application (ref. I/7031/MEDL) as the use of a roughened surface provides a greatly improved adherence and bonding of the polymer inks to the plastics substrate. With the use of this roughened surface the bonding of the polymer inks to the plastics material is sufficiently good as to permit the attachment of relatively heavy electrical and electronic components to the electrical conductive ink tracks without pulling the tracks away from the plastic.

The invention is further described, by way of example, with reference to the accompanying drawing, in which:

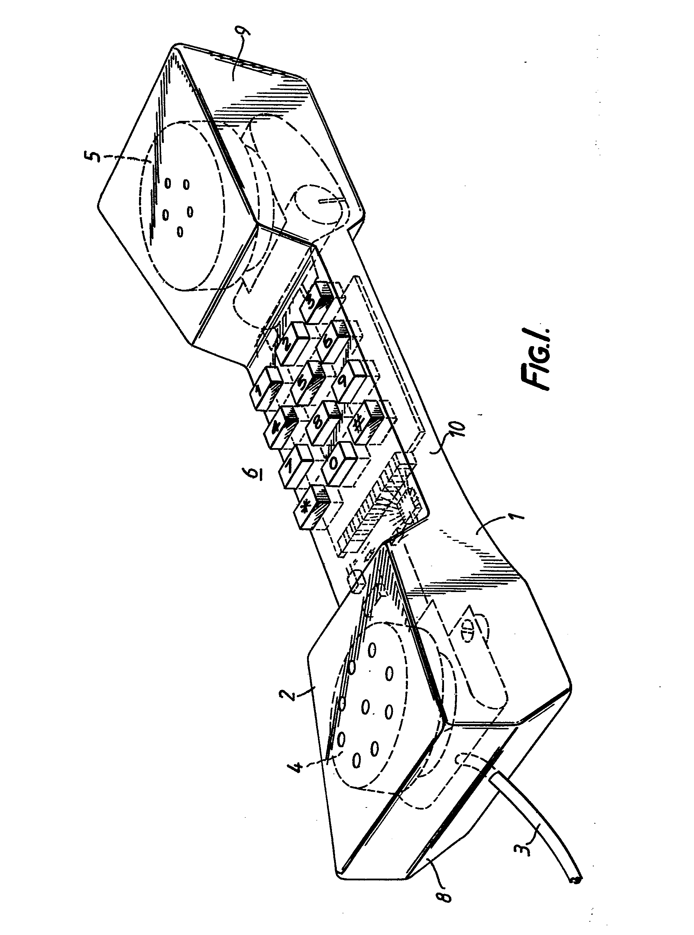

Figure 1 is a perspective view of the circuit arrangement in accordance with the invention, and

Figure 2 is a sectional view of two of its component parts.

Referring to the drawings, the electrical arrangement consists of the telephone hand-set which is formed of a housing having a base 1 and an upper cover 2 both of which are formed as a moulded thermo-setting plastic material. An electrical lead 3 is attached to one end of the hand-set and an enlarged adjacent portion 8 contains a microphone 4. An enlarged portion 9 at the other end of the hand-set contains the ear-piece 5. The central narrow bridging portion 10 carries a push-button set 6 which is used for the conventional dialling purposes. The interior of the hand-set contains the electrical circuits which are necessary to facilitate the operation of the telephone, to enable it to receive incoming calls and to enable it to dial out to an exchange when an outgoing call is required. Such a telephone hand-set can be termed a one-piece telephone as all the functions are included within the one structure.

Conventionally, these circuit functions have previously been provided by small, flat, rigid, printed circuit boards each carrying a circuit layout and electronic components mounted within the housing. The provision of these circuit boards represents an additional step which is expensive to perform in its own right, and which subsequently have to be attached in a rigid and satisfactory manner to the housing of the hand-set. To a significant extent, these internally mounted circuit boards dictate the size, shape and weight of a product such as the telephone hand-set.

By way of contrast, in accordance with this invention, the base 1 and the cover 2 themselves act as substrates for the electrical circuits, despite the fact that they are designed primarily with their structural functions and appearance in mind. The circuits for example are located on just those regions 11, 12 of the base 1 and cover 2 which are provided with an internally roughened surface,as it is found that the low temperature polymer inks adhere more satisfactorily to such a surface.

To form the base 1 or the cover 2, mould tools are formed of a metal such as steel, and those regions of its surface corresponding to regions 11, 12 of the final product are roughened by means of a controlled spark erosion process to the required extent. Alternatively, the roughness can be produced by an acid etch or by sand blasting. Typically, the correct degree of roughness is 33 on the VDI scale and 4.5 on the RA scale - this roughness is determined by the need for a good adherence between the ink and the substrate.

Plastics granules, e.g. that known as polysulfone, is injection moulded under pressure of about 1380 Bar at a mould temperature of about 95°C, and a material temperature of about 395°C using the roughened mould tool to determine the shape. The apertures for the push-button switches are moulded into the cover at this time. Instead of moulding in the roughness, the moulded plastics members can be subsequently roughened by sand blasting or the use of a plasma etch. After moulding, electrical polymer ink is screen printed on to the roughened surface, using a patterned mesh as the mask. Screen printing is in itself quite conventional. The printed inks are then cured at about 150°C - such a temperature does not damage the moulded plastics members. The ink is chosen in dependence on the electrical properties required, i.e. conductive, resistive or capacitive. Suitable low temperature curing polymer inks are available from Electro-science Laboratories Inc., under type numbers 1109-S, RS-150 series, and 240-SB.

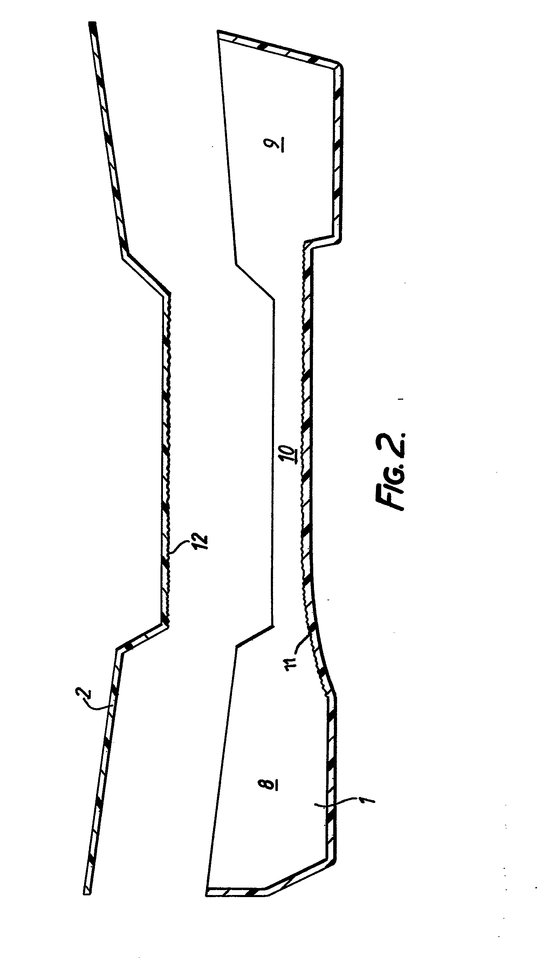

Following the curing, the plastics members are as shown in Figure 2. The inks can be electrolessly plated, as is described in our co-pending patent application (ref. I/7033/MEDL), as this then permits electrical components to be mounted directly on to the printed tracks using conventional solder. The microphone and ear-piece are then mounted, and linked to the printed circuits using flexible connectors.

In Figure 2 it will be apparent that the roughened region 12, on which a circuit is printed, is flat, whereas the region 11 is curved. However, the supporting substrate for the region 12 is the cover 2, which is not flat, but is a three-dimensional moulding. The curved region 11 acts as the substrate upon which the circuits can be formed by the use of printing screen or stencils, and circuits could be printed directly on to roughened surfaces which have more complex profiles, if desired.

- 8 -

0203680

CLAIMS

1.    An electrical circuit including a shaped non-flat electrically insulating moulded plastics substrate, a surface region of which carries circuit elements formed of a low temperature cured electrical ink of the kind which cures at a temperature of less than 200$^{\circ}$C.

2.    An electrical arrangement including a structural non-flat member formed of a moulded plastics material, a portion of the structural member also serving as a substrate for an electrical circuit which is formed at least partly of a low-temperature cured electrical ink which is cured in contact with the plastics material.

3.    An arrangement as claimed in claim 2 and wherein said structural member is part of a three-dimensional housing for the arrangement.

4.    An arangement as claimed in claim 2, and wherein the region of the member which acts as the substrate for the electrical circuit is provided with a roughened surface to enhance the adhesion of the electrical ink thereto.

5.    An arrangement as claimed in claim 2, 3 or 4 and wherein said ink is a polymer ink.

6.    An arrangement as claimed in claim 2, 3, 4 or 5 and wherein said structural non-flat members, together with one or more structural members of a moulded plastics material which also carry electrical circuit elements in the form of low-temperature cured electrical inks constitute the entire housing for the arrangement.

7.  An arrangement as claimed in any of claims 2 to 6 and wherein said electrical arrangement is a telephone hand-set.

Fig.1.

*FIG. 2.*